# EUROPEAN PATENT SPECIFICATION

(11) **EP 1 770 832 B1**
(45) Date of publication and mention of the grant of the patent: **02.12.2009**
(21) Application number: 05021514.4
(22) Date of filing: 30.09.2005
(51) Int. Cl.: H01R 13/66

(54) **Telecommunications plug, an assembly including a telecommunications module and a plug, and a method of manufacturing a plug**
Stecker für Telekommunikation, Anordnung mit einem Telekommunikationsmodul und einem Stecker, und Herstellungsverfahren für einen Stecker
Fiche pour télécommunication, ensemble comprenant un module et une fiche, et méthode de fabrication d'une fiche

(43) Date of publication of application: 04.04.2007
(73) Proprietor: 3M Innovative Properties Company, St. Paul MN 55133-3427 (US)
(72) Inventor: Bonvallat, Pierre, St. Paul, MN 55133-3427 (US); Koruschowitz, Axel, St. Paul, MN 55133-3427 (US); Metral, Guy, St. Paul, MN 55133-3427 (US); Perrier, Gaetan, St. Paul, MN 55133-3427 (US)
(74) Representative: Bergen, Katja

(56) References cited:
- EP-A- 0 637 176
- WO-A-03/090322
- US-A1- 2004 082 223

## Description

### Technical field

The invention relates to a plug in the field of telecommunications, an assembly including at least one telecommunications module and at least one plug as well as a method for manufacturing the plug.

### Background

In the field of telecommunications, numerous customers are connected with the switch of a telecommunications company via telecommunications lines. The customers can also be called subscribers. The switch is also called an exchange or PBX (central office exchange operated by the telecommunications company). Between the subscriber and the switch, sections of the telecommunications lines are connected with telecommunications modules. The telecommunications modules establish an electrical connection between a wire, which is attached to the telecommunications module at a first side, and another wire, which is attached to the telecommunications module at a second side. The wires of one side can also be called incoming wires and the wires of the other side can be called outgoing wires. Plural telecommunications modules can be put together at a distribution point, such as a main distribution frame, an intermediate distribution frame, an outside cabinet or a distribution point located, for example, in an office building or on a particular floor of an office building. To allow flexible wiring, some telecommunications lines are connected with first telecommunications modules in a manner to constitute a permanent connection. Flexibility is realized by so-called jumpers or cross connects, which flexibly connect contacts of the first telecommunications module with contacts of a second telecommunications module.

These jumpers can be changed when a person moves within an office building to provide a different telephone (i.e. a different telephone line) with a certain telephone number, which the relocated person intends to keep. In the telecommunications module, disconnection points can be located in the electrical connection between the two sides. At such disconnection points, disconnection plugs can be inserted, in order to disconnect the line. Furthermore, protection plugs and magazines are known. These are connected to the module and protect any equipment connected to the wires from overcurrent and overvoltage. Finally, test plugs can be inserted at a disconnection point in order to test or monitor a line.

Recently, ADSL-technology has spread widely in the field of telecommunications. This technology allows at least two different signals to be transmitted on a single line. This is achieved by transmitting the different signals at different frequencies along the same line. The signals are combined at a particular point in the telecommunications line and split at another point. In particular, at the subscriber side, voice and data signals, which are separate, are combined and sent to the central office via the same line.
In the central office the combined signal is split. The voice signal is then directed to the other subscriber(s) on the telephone call, and the data signal is directed to the other subscriber(s) participating in the data exchange. For the transmission of voice and data signals to the subscriber, separate voice and data signals are combined at the central office, sent to the subscriber and split at the subscriber side. After splitting the signal, the so-called POTS-signal (plain old telephone service) can be used to transmit voice signals. The remaining part of the split signal can be used to transmit data, for example. So-called splitters, which are used to split or combine the signal, can generally be arranged at any distribution point.

Any electronic components which are necessary to perform the above functions can be contained, possibly together with a printed circuit board as a base, in a functional module, which can be called a splitter module or plug. Similar functional modules are protection modules or plugs, which contain any components which provide protection against overvoltage and/or overcurrent, as well as testing and monitoring modules or plugs, which contain suitable electronic components and circuits in order to test and/or monitor a telecommunications line. Furthermore, other functional modules or plugs in the above sense are known to those skilled in the art.

EP 1 455 543 A1 describes an assembly of a telecommunications module and at least one protection plug according to the preamble of claim 1, wherein the protection plug can contain a printed circuit board.

US 2003/0043970 A1 is related to a splitter card which can include a first printed circuit board as a main board and one or more printed circuit boards as daughter boards.

### Summary of the invention

The invention provides a plug in the field of telecommunications, according to claim 1, in which the required functional components can be arranged in a well organized and/or space saving manner. Moreover, an assembly including at least one such plug as well as a method for manufacturing such a plug are provided.

The novel plug includes a housing and is connectable with contacts of a telecommunications module. The telecommunications module can comprise a housing. The housing can be made of plastic or any other suitable material and can be constituted by one or more components. The housing serves to accommodate telecommunications contacts, to which telecommunications lines are connectable. The housing can also have specific structures for positioning the contacts therein. Moreover, the housing can comprise one or more cavities or receiving spaces, which are adapted to accommodate the contacts and/or objects such as one or more plugs described below or any other types of outside modules or parts thereof. Finally, the housing can comprise suitable structures, typically at the outside thereof, to enable the telecommunications module to be mounted to a rack or any other suitable carrier in the field of telecommunications.

The novel plug includes a housing, which can be formed of one or more housing parts made of plastic or any other suitable material, in order to accommodate the components and/or circuits mentioned below. Moreover, the housing can have one or more projections, grooves or other suitable structures, which cooperate with corresponding structures at the telecommunications module, such as recesses, projections, ridges and/or openings, in order to securely locate the plug when it is fitted to the telecommunications module.
Moreover, the plug can comprise one or more projections which serve to allow an easy gripping and handling of the plug in order to fit it to the telecommunications module or remove it therefrom. In particular, the plug itself, i.e. that part which is, with its projections or the like, "plugable" into a telecommunications module, includes at least one functional component and at least two printed circuit boards, as detailed below. In this respect, the novel plug differs from known plugs, which can be plugged into a telecommunications module, but are, by cables, connected to a separate device which possibly includes functional components and/or printed circuit boards. Thus, the invention provides a plugable device, which includes functional components and printed circuit boards.

The telecommunications module, to which the plug can be fitted, includes telecommunications contacts, to which telecommunications lines are connectable. As will be apparent to those skilled in the art, a telecommunications line will normally be constituted by a pair of wires, so that the telecommunications contacts are also arranged in pairs. Moreover, telecommunications modules are known in which the telecommunications contacts are arranged in two or more parallel rows, with pairs of contacts being located opposite to each other. Thus, the telecommunications modules can have the shape of a strip.

The plug has at least one functional component. The functional components can, for example, be overvoltage and/or overcurrent protectors. Moreover, the plug can include one or more filters, which can, for example, constitute one or more splitter circuits. Furthermore, one or more testing circuits and/or components, which allow testing one or more telecommunications lines or devices connected thereto, can be included in the plug. The plug can also include one or more coding components and/or circuits which can, for example, render the plug a type of electronic key which will make the plug compatible only with specific types of telecommunications modules. Such an embodiment can be called a coded plug. The above-mentioned embodiments can be called protection and/or splitter and/or testing plugs.

The plug described herein further includes at least two printed circuit boards. This allows a particularly well-organized and/or compact arrangement of functional components on the plug. For example, different types of functional components can be separated from each other by arranging a first type of functional components on a first printed circuit board and arranging a second type of functional components on a second printed circuit board. In this manner, protection components can, for example, be separated from other types of components, which can, for example, be filters used to provide a splitter circuit. Moreover, any components that require maintenance and/or replacement or are easily damaged, can be arranged on a first, for example, an upper printed circuit board, and other components, for example more expensive components, can be arranged on a second, for example lower printed circuit board. Thus, access to those components, which require maintenance and/or replacement, is advantageously provided. Those components that might have to be replaced more often can be more easily accessed than others, as they can be arranged on an upper printed circuit board that can be easily accessed. Moreover, any cheaper, disposable components can be arranged on that printed circuit board through which the electricity flows first, so that any more expensive components can be protected more effectively.

Moreover, by arranging at least two printed circuit boards in the plug, the "third dimension", i.e. a thickness direction of a printed circuit board, can advantageously be used. Thus, not only the two dimensions in the plane of a single, flat printed circuit board are used. Rather, at least one additional printed circuit board is provided which can, for example, be arranged substantially parallel to and spaced from the first printed circuit board, so that functional components are arranged on top of each other as regards a thickness direction of the printed circuit boards. This allows the length and width dimensions of the plug to be reduced in the directions lying in the plane of the printed circuit boards. In some applications, a somewhat "thicker" extension of the plug in this direction does not interfere with other components, which might be present. Thus, the available space is efficiently used. However, the printed circuit boards do not necessarily have to be completely inside the plug. Rather, they can protrude, at least partially, from the housing of the plug.

Two printed circuit boards can, for example, be arranged substantially parallel to each other.

Moreover, two printed circuit boards can be arranged at least partially overlapping, i.e. the projection of one printed circuit board onto the plane of another printed circuit board can coincide, at least partially, with the other printed circuit board. With such a configuration, the above-referenced thickness direction of the printed circuit boards is used in a particularly efficient manner, as the size in the remaining two directions, i.e. in the directions lying in the plane of the printed circuit boards can be kept small. However, two or more printed circuit boards can also be arranged at an angle or substantially perpendicular to each other or in any other position relative to each other, which is suitable for a particular application.

Generally, particularly when separate printed circuit boards provide separate functions, the printed circuit boards can be separate from each other and are separately connected with contacts, which are adapted to be connected with contacts of the telecommunications module. Moreover, mechanical positioning of one or more printed circuit boards can be performed by suitable contours provided on one or more inner faces of the housing of the plug. However, these aspects can be covered particularly efficiently when two printed circuit boards are electrically and/or mechanically connected with each other. This allows the electrical connection to the telecommunications module and/or the contours for mechanically positioning the one or more printed circuit boards to be kept simple. As regards the electrical connection, such a connection can, for example, be used to provide circuit layouts on the printed circuit boards which are adapted to have electrical current, which enters the plug, pass through a first printed circuit board that provides, for example, overcurrent and/or overvoltage protection. Then the current can flow through a second printed circuit board that includes, for example, a splitter circuit. However, the printed circuit boards can also be electrically isolated from each other and current can flow through them in parallel, for example when one circuit board provides test and/or measurement functions and the second provides other functions such as uninterrupted "life-line" telephone service.

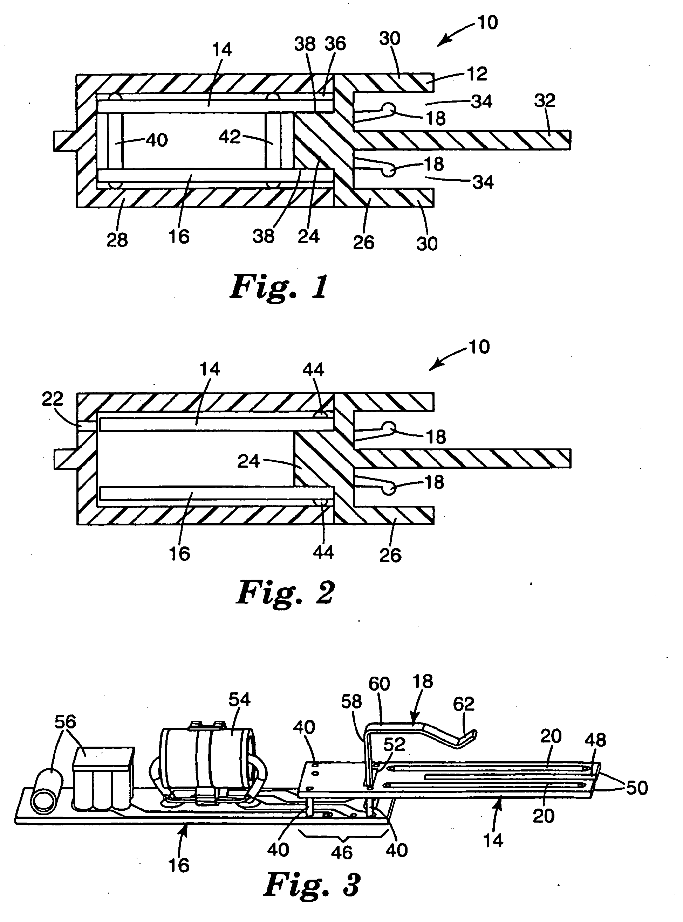

As regards the mechanical connection, this connection can, generally, be an indirect one, or components, which have primarily a different purpose, such as housing parts, can be used to position the printed circuit boards relative to each other. However, advantages have been found for a modification in which specific mechanical connectors, such as one or more pins (see pins 40, 42 in Figs. 1 and 3) are used.

In order to provide efficient interconnection with contacts of a telecommunications module, the plug can include at least one plug contact, which is exposed so as to establish a connection with a contact of the telecommunications module. In particular, the one or more plug contact(s) can extend outside the plug's housing, and can also assist in guiding the plug into the appropriate location with respect to the module.

The electrical connection between a plug contact and one or more printed circuit boards can be made particularly efficient when the plug contact extends through at least one printed circuit board. In this manner, electrical connection can, firstly, be established with the printed circuit board through which the plug contact extends. Secondly, the portion of the plug contact that extends through the first printed circuit board can be used to establish an electrical connection with a second printed circuit board.

The structure of the novel plug can be kept simple when at least one printed circuit board includes at least one contact section, which is exposed so as to establish a connection with a contact of a telecommunications module. Thus, at least one plug contact, as mentioned above, is constituted by a contact section of the printed circuit board. In other words, for establishing electrical connection between the printed circuit board and the contact of the telecommunications module, a separate extending plug contact can be eliminated. Rather, contact sections on the printed circuit board are used to establish direct electrical connection with the contacts of the telecommunications module.

The novel plug can be made particularly compact when at least one printed circuit board includes functional components on both sides thereof. The term "sides" of a printed circuit board refers to the major surfaces of the generally flat printed circuit board, as compared to the edges, the depth of which corresponds to the thickness of the printed circuit board. Thus, at least one printed circuit board can advantageously be used on both sides. This adds to the above-described advantage of making a compact and space efficient plug.

The plug can, for example, include at least one splitter circuit, in order to allow splitting or combining of telecommunications signals. In this context, the novel plug can comprise a single splitter circuit, which is adapted to split or combine the signal transmitted through a single telecommunications line. Such a plug is particularly cost efficient. With this embodiment, a telecommunications module can be equipped with such splitter plugs at a time when an individual subscriber desires ADSL services. Thus, the costs of providing the required equipment can be delayed until a point in time when the need actually arises, as opposed to having to provide multi-line multi-splitter modules that are installed even when only one new subscriber requests service. As an alternative, the novel plug can also include more splitter circuits in order to allow for ADSL services for a higher number of subscribers at one and the same time.

Moreover, the novel plug can also include at least one protection component such as overvoltage and/or overcurrent protectors. In particular, the plug can include both one or more splitter circuits and one or more protection components. Alternatively, or in addition thereto, coding components and/or circuits, one or more displays, one or more relays, as well as testing components and/or circuits can be included.

In order to enable testing of the plug itself, of one or more telecommunications lines and/or equipment connected therewith, the novel plug can include at least one opening or port that provides test access. Thus, the opening is, for example, formed in the housing and allows access to one or more contact(s), component(s) or circuit(s) of the plug in order to perform the described testing. In one embodiment, the opening or port is provided on the side of the plug opposite where contacts extend to connect the plug to a module.

Examples of types of testing that may be performed include electrical testing such as isolation testing, lead through resistance testing, transmission performance testing, fault testing (locating a fault at a point or within a range of positions along a line), etc.

It provides advantages if two printed circuit boards are positioned at a fixed distance from each other, for example, to protect any electronic components or circuits thereon. Such a distance can be realized efficiently by forming the housing so as to include at least one spacer, which is arranged between two printed circuit boards. Such a spacing contour can easily be provided on the housing, which can, for example, be made of molded plastic. The housing can thus support each circuit board at one or more locations on or along the board.

The novel plug can be provided so as to be fittable to a telecommunications module that is already installed at a distribution point, such as a main distribution frame. However, an assembly such as a distribution point and preferably a main distribution frame, including at least one telecommunications module, and at least one plug, as described above, is to be considered subject matter of the present application.

The invention further provides a method of manufacturing a plug according to claim 1, including a housing and at least one functional component and being connectable with contacts of a telecommunications module, including the step of fitting at least two printed circuit boards to the plug. For example, they can be arranged in or on the plug. This method can be performed in an efficient and cost saving manner and is suitable for manufacturing the above-described plug. Preferred variants of the novel method essentially correspond to the preferred embodiments of the novel plug as described herein.

### Brief description of the drawings

Hereinafter, the invention will be described by non-limiting examples thereof with reference to the drawings, in which:
Fig. 1 shows a sectional view of a first embodiment of the novel plug;
Fig. 2 shows a sectional view of a second embodiment of the novel plug;
Fig. 3 shows the printed circuit boards of a third embodiment of the novel plug.

### Description of preferred embodiments of the invention

Fig. 1 shows a sectional view of the novel plug 10 including a housing 12, which has, in the embodiment shown, a first housing part 26 and a second housing part 28. In the embodiment shown, the first housing part 26 is adapted to face a telecommunications module (not shown), to which the plug 10 is fittable. For this purpose, the first housing part 26 includes two lateral protrusions 30 and one central protrusion 32, which is, in the embodiment shown, longer than the lateral protrusions 30. In the case shown, the protrusions are substantially parallel to each other. The protrusions 30, 32 can, for example, serve to position the plug relative to the telecommunications module. This can be realized by interaction between the protrusions 30 and suitable, substantially complimentary channels, passageways, or other surface characteristics or contours formed on the telecommunications module. For example, the central protrusion 32 can be insertable into a cavity formed in the telecommunications module, one result of which can be the proper positioning of the plug relative to the module.

The central protrusion 32 can also serve to disconnect from each other the contacts of the telecommunications module that otherwise are in contact with each other at a disconnection point. In this context, plug contacts 18, which are exposed, can establish electrical contact with the contacts of the telecommunications module. Thus, these contacts of the telecommunications module can, by the plug contacts 18, be connected with any functional components on printed circuit boards 14, 16 of the plug 10. In the embodiment shown, plug contacts 18 are accommodated in recesses 34, which are formed between the central protrusion 32 and each of the lateral protrusions 30. In particular, the plug contacts 18 are, in the embodiment shown, shorter than the lateral protrusions 30, so that they are, particularly when the plug 10 is being handled before it is fitted to a telecommunications module or when it has been removed there from, protected against damage.

The first housing part 26 is, in the embodiment shown, formed as a base and the second housing part 28 is formed as a type of cap so as to define an interior 36 of the housing 12. In the interior 36, two printed circuit boards 14, 16 are arranged. Additional circuit boards could be provided, if desired. In the embodiment shown, the first housing part 26 includes a spacer 24, which faces the interior 36. The spacer 24 is essentially formed as a comparably wide protrusion with steps 38 being defined on the sides thereof. These steps 38 are used to arrange the printed circuit boards 14, 16 and, particularly, space them from each other. Thus, in the embodiment shown, that side of each printed circuit board 14, 16, which faces the other printed circuit board 16, 14, can be used for arranging functional components thereon. Due to the spacer 24, the components arranged on the printed circuit boards 14, 16 will not interfere with each other. As an alternative, a spacer can be provided on one or both housing parts 26, 28. Such an embodiment is described below with reference to Fig. 2. However, to space apart two printed circuit boards, they can also be retained in a fixed relationship to each other in alternative ways. For example, one or both housing parts 26, 28 can have suitable structures, such as one or more grooves, which are adapted to position a printed circuit board. Also in this way, two or more printed circuit boards can be kept in a fixed relationship to each other and be spaced from each other. In particular, a suitable structure such as a groove or a slot can be provided in one of the housing parts, for example, the second housing part 28, particularly at a location remote from the plug contacts 18. Moreover, the plug contacts 18 can be fixed on the printed circuit board and the position of the plug contact 18 can be defined by the first and/or second housing part. Thus, via the plug contacts 18, the printed circuit board is in a defined position also on the side of the plug contacts 18.

In the embodiment shown, the printed circuit boards 14,16 are additionally electrically and mechanically connected with each other. This is, in the embodiment shown, achieved by two pins 40, 42. In the case shown, a first pin 42 is arranged relatively close to the spacer 24. The second pin 40 is arranged at a location remote from the spacer 24. This positioning enhances the mechanical stability of the arrangement. One or both pins 40, 42 can additionally be used to establish an electrical connection between the printed circuit boards 14, 16. As can also be seen in Fig. 1, the printed circuit boards 14, 16 are arranged substantially parallel to each other. Moreover, in the embodiment shown, both printed circuit boards 14, 16 are arranged relatively close to the walls of the second housing part 28 so that, in the embodiment shown, the available space is efficiently used, for example, by arranging functional components on the printed circuit boards in the space that is present between them.

Fig. 2 shows an embodiment similar to that of Fig. 1. The main difference, compared with the embodiment of Fig. 1, is the arrangement of the printed circuit boards 14, 16. In the embodiment of Fig. 2, there is no connection between the printed circuit boards 14, 16. Rather, both printed circuit boards 14, 16 are mechanically attached to the spacer 24 provided on the first housing part 26 by fastening pins 44. In the embodiment of Fig. 1 and 2, the printed circuit boards 14, 16 entirely overlap each other. In other words, the printed circuit board are substantially the same size and overlie each other. However, it is also possible to have printed circuit boards with differing sizes so that they overlap only partially, or to have them the same size but overlapping only partially. One of the printed circuit board 14, 16 could be used to provide the functional components and circuits that are necessary to provide one or more splitter circuits. The other printed circuit board 16, 14 can be used to provide the components required for overvoltage and/or overcurrent protection. An optional opening, that can provide test access, is indicated at 22.

Fig. 3 shows the printed circuit boards, functional components and contacts of a third embodiment of the novel plug. This embodiment differs from the above-described embodiments, firstly with regard to the arrangement of the printed circuit boards. The printed circuit boards 14, 16 are again arranged substantially parallel to each other. However, they only overlap in a small overlapping area 46 and are mechanically and/or electrically connected with each other by, in the embodiment shown, four pins 40. Moreover, in the embodiment of Fig. 3, the first printed circuit board 14 itself has plug contacts formed thereon by providing contact sections 20 on the printed circuit board. These contact sections 20 are adapted to establish electrical connection with the contacts of a telecommunications module (not shown). Moreover, in the embodiment shown over approximately two thirds of its length (extending from left to right in Fig. 3) the printed circuit board 14 comprises a slit 48 so that two legs 50 are defined between the slit and each of the side edges of the approximately rectangular printed circuit board 14. Thus, in the case shown, at least two separate contact sections 20 can be provided. It can also be mentioned that further separate contact sections can be provided at the upper and lower side of each leg 50. Thus, for the embodiment shown, a total of four separate contact sections 20 can be defined.

The printed circuit board 14, in the case shown, further comprises an opening 52, which is at least partially located in the overlapping area 46. This opening 50 allows a plug contact 18 to pass through the first printed circuit board 14, so that it can be connected with the second printed circuit board 16. The plug contact 18 can, for example, be a grounding contact. Such a grounding contact can be provided for conducting overcurrent and/or overvoltage to ground.

This can, for example, be performed by an overvoltage protector 54, with which the plug of Fig. 3 is equipped. Further functional components can be seen at 56. The functional components 54, 56 are, in the case shown, arranged on that side relative to printed circuit board 16, where also printed circuit board 14 is located. Moreover, circuits (not visible in the drawing of Fig. 3) are provided on one or both printed circuit boards 14, 16, in order to allow the desired functions, such as protection, splitting, testing, coding etc., to be performed.

In the embodiment shown, the plug contact 18 has a first portion 58, which is substantially perpendicular to the second printed circuit board 16 and extends through the opening 52. A second portion 60 is bent approximately 90° with regard to the first portion 58 and comprises a flat V-shaped end 62. With this shape, reliable insertion and the establishment of electrical connection with a grounding element at the telecommunications module (not shown) can be achieved. In particular, resiliency of the plug contact 18 in the vertical direction of Fig. 3 can be used to provide a reliable electrical contact.

The present invention has now been described with reference to several embodiments thereof. The foregoing detailed description and embodiment have been given for clarity of understanding only. No unnecessary limitations are to be understood there from. For example, all references to left and right sides, upper and lower levels, directions etc., are exemplary only and do not limit the claimed invention. It will be apparent to those skilled in the art that many changes can be made to the embodiment described without departing from the scope of the invention. Thus, the scope of the present invention should not be limited to the exact details and structures described herein, but rather by the structures described by the language of the claims, and the equivalents of those structures.

## Claims

1. A plug (10) including a housing (12) and at least one functional component (54, 56) and being connectable with contacts of a telecommunications module,
**characterized in that** the plug (10) includes at least two printed circuit boards (14, 16) and the printed circuit boards are separately connected with contacts, which are adapted to be connected with contacts of the telecommunications module.

2. The plug in accordance with claim 1, wherein at least two printed circuit boards (14, 16) are arranged substantially parallel to each other.

3. The plug in accordance with claim 1 or 2, wherein at least two printed circuit boards (14, 16) at least partially overlap each other.

4. The plug in accordance with any of the preceding claims, wherein at least two printed circuit boards (14, 16) are electrically connected with each other.

5. The plug in accordance with any of the preceding claims, wherein at least two printed circuit boards (14, 16) are mechanically directly connected with each other.

6. The plug in accordance with any of the preceding claims, wherein the plug (10) includes at least one plug contact (18), which is exposed so as to establish a connection with a contact of the telecommunications module and which extends through at least one printed circuit board (16).

7. The plug in accordance with any of the preceding claims, wherein at least one of the printed circuit boards (16) includes at least one contact section (20) thereon, which is exposed so as to establish a connection with a contact of the telecommunications module.

8. The plug in accordance with any of the preceding claims, wherein at least one printed circuit board (14) includes at least one functional component (54, 56) on both sides thereof.

9. The plug in accordance with any of the preceding claims, including at least one splitter circuit.

10. The plug in accordance with any of the preceding claims, including at least one protection component (54).

11. The plug in accordance with any of the preceding claims, wherein the housing (12) includes at least one opening (22) which provides test access.

12. The plug in accordance with claim 11, wherein the test access can be used to perform electrical testing, such as isolation testing, lead through resistance testing or transmission performance testing.

13. The plug in accordance with any of the preceding claims, wherein the housing includes at least one spacer (24), which is arranged between two printed circuit boards (14, 16).

14. An assembly, such as a distribution point, in particular a main distribution frame, including at least one telecommunications module and at least one plug (10) in accordance with any of the preceding claims.

15. A method of manufacturing a plug according to claim 1, including a housing and at least one functional component, which is connectable with contacts of a telecommunications module, including the step of fitting at least two printed circuit boards to the plug.

## Patentansprüche

1. Stecker (10), enthaltend ein Gehäuse (12) und mindestens eine Funktionskomponente (54, 56), der mit Kontakten eines Telekommunikationsmoduls verbindbar ist, **dadurch gekennzeichnet, dass** der Stecker (10) mindestens zwei Leiterplatten (14, 16) enthält und die Leiterplatten getrennt mit Kontakten verbunden sind, die dazu ausgelegt sind, mit Kontakten eines Telekommunikationsmoduls verbunden zu werden.

2. Stecker nach Anspruch 1, wobei mindestens zwei Leiterplatten (14, 16) im Wesentlichen parallel zueinander angeordnet sind.

3. Stecker nach Anspruch 1 oder 2, wobei sich mindestens zwei Leiterplatten (14, 16) zumindest teilweise überlappen.

4. Stecker nach einem der vorhergehenden Ansprüche, wobei mindestens zwei Leiterplatten (14, 16) elektrisch miteinander verbunden sind.

5. Stecker nach einem der vorhergehenden Ansprüche, wobei mindestens zwei Leiterplatten (14, 16) mechanisch direkt miteinander verbunden sind.

6. Stecker nach einem der vorhergehenden Ansprüche, wobei der Stecker (10) mindestens einen Steckerkontakt (18) enthält, der frei liegt, damit eine Verbindung mit einem Kontakt des Telekommunikationsmoduls hergestellt wird, und der sich durch mindestens eine Leiterplatte (16) hindurch erstreckt.

7. Stecker nach einem der vorhergehenden Ansprüche, wobei mindestens eine der Leiterplatten (16) mindestens einen Kontaktabschnitt (20) daran enthält, der frei liegt, damit eine Verbindung mit einem Kontakt des Telekommunikationsmoduls hergestellt wird.

8. Stecker nach einem der vorhergehenden Ansprüche, wobei mindestens eine Leiterplatte (14) mindestens eine Funktionskomponente (54, 56) an beiden Seiten davon enthält.

9. Stecker nach einem der vorhergehenden Ansprüche, enthaltend mindestens eine Teilerschaltung.

10. Stecker nach einem der vorhergehenden Ansprüche, enthaltend mindestens eine Schutzkomponente (54).

11. Stecker nach einem der vorhergehenden Ansprüche, wobei das Gehäuse (12) mindestens eine Öffnung (22) enthält, die Prüfungszugang bietet.

12. Stecker nach Anspruch 11, wobei der Prüfungszugang zur Durchführung von elektrischen Prüfungen, wie Isolierprüfung, Durchführungswiderstandsprüfung oder Übertragungsleistungsprüfung, verwendet werden kann.

13. Stecker nach einem der vorhergehenden Ansprüche, wobei das Gehäuse mindestens einen Abstandhalter (24) enthält, der zwischen zwei Leiterplatten (14, 16) angeordnet ist.

14. Anordnung, wie ein Verteilungspunkt, insbesondere ein Hauptverteiler, enthaltend mindestens ein Telekommunikationsmodul und mindestens einen Stecker (10) gemäß einem der vorhergehenden Ansprüche.

15. Verfahren zur Herstellung eines Steckers nach Anspruch 1, enthaltend ein Gehäuse und mindestens eine Funktionskomponente, der mit Kontakten eines Telekommunikationsmoduls verbindbar ist, enthaltend den Schritt des Anbringens von mindestens zwei Leiterplatten an den Stecker.

## Revendications

1. Fiche (10) comprenant un boîtier (12) et au moins un élément fonctionnel (54, 56) et étant connectable avec des contacts d'un module de télécommunications,
**caractérisée en ce que** la fiche (10) comprend au moins deux cartes de circuit imprimé (14, 16) et ces cartes de circuit imprimé sont connectées séparément avec des contacts, qui sont adaptés de façon à être connectés avec des contacts du module de télécommunications.

2. Fiche selon la revendication 1, dans laquelle au moins deux cartes de circuit imprimé (14, 16) sont disposées essentiellement parallèlement l'une à l'autre.

3. Fiche selon la revendication 1 ou 2, dans laquelle au moins deux cartes de circuit imprimé (14, 16) se chevauchent au moins partiellement l'une l'autre.

4. Fiche selon l'une quelconque des revendications précédentes, dans laquelle au moins deux cartes de circuit imprimé (14, 16) sont connectées électriquement l'une avec l'autre.

5. Fiche selon l'une quelconque des revendications précédentes, dans laquelle au moins deux cartes de circuit imprimé (14, 16) sont connectées mécaniquement directement l'une avec l'autre.

6. Fiche selon l'une quelconque des revendications précédentes, dans laquelle la fiche (10) comprend au moins un contact de fiche (18), qui est exposé de façon à établir une connexion avec un contact du module de télécommunications et qui s'étend à travers au moins une carte de circuit imprimé (16).

7. Fiche selon l'une quelconque des revendications précédentes, dans laquelle au moins une des cartes de circuit imprimé (16) comprend au moins une section de contact (20) sur elle, qui est exposée de façon à établir une connexion avec un contact du module de télécommunications.

8. Fiche selon l'une quelconque des revendications précédentes, dans laquelle au moins une carte de circuit imprimé (14) comprend au moins un élément fonctionnel (54, 56) sur ses deux côtés.

9. Fiche selon l'une quelconque des revendications précédentes, comprenant au moins un circuit diviseur.

10. Fiche selon l'une quelconque des revendications précédentes, comprenant au moins un composant de protection (54).

11. Fiche selon l'une quelconque des revendications précédentes, dans laquelle le boîtier (12) comprend au moins une ouverture (22) qui fournit un accès pour les contrôles.

12. Fiche selon la revendication 11, dans laquelle on peut utiliser l'accès pour les contrôles afin d'effectuer des contrôles électriques, tels que le contrôle de l'isolement, le contrôle de la résistance de traversée ou le contrôle de la qualité de transmission.

13. Fiche selon l'une quelconque des revendications précédentes, dans laquelle le boîtier comprend au moins une pièce d'écartement (24), qui est disposée entre deux cartes de circuit imprimé (14, 16).

14. Ensemble, tel qu'un point de répartition, en particulier un répartiteur principal, comprenant au moins un module de télécommunications et au moins une fiche (10) selon l'une quelconque des revendications précédentes.

15. Procédé de fabrication d'une fiche selon la revendication 1 comprenant un boîtier et au moins un élément fonctionnel, qui est connectable avec les contacts d'un module de télécommunications, comprenant l'étape consistant à monter au moins deux cartes de circuit imprimé sur la fiche.
